(19) Europäisches Patentamt
European Patent Office
Office européen des brevets

(11) **EP 3 299 831 B1**

(12) **FASCICULE DE BREVET EUROPEEN**

(45) Date de publication et mention de la délivrance du brevet:
**16.08.2023 Bulletin 2023/33**

(21) Numéro de dépôt: **17191935.0**

(22) Date de dépôt: **19.09.2017**

(51) Classification Internationale des Brevets (IPC):
**G01R 33/26** (2006.01)

(52) Classification Coopérative des Brevets (CPC):
**G01R 33/26**

(54) **RÉSEAU DE MAGNÉTOMÈTRES VECTORIELS ET PROCÉDÉ ASSOCIÉ DE CALIBRATION DES COUPLAGES ENTRE MAGNÉTOMÈTRES**

NETZ AUS VEKTORIELLEN MAGNETOMETERN, UND ZUGEHÖRIGES VERFAHREN ZUR KALIBRIERUNG DER KOPPLUNGEN ZWISCHEN MAGNETOMETERN

NETWORK OF VECTOR MAGNETOMETERS AND ASSOCIATED METHOD FOR CALIBRATING COUPLINGS BETWEEN MAGNETOMETERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2016 FR 1659027**

(43) Date de publication de la demande:
**28.03.2018 Bulletin 2018/13**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **LE PRADO, Matthieu**
**38160 SAINT-MARCELLIN (FR)**
• **BERTRAND, François**
**38180 SEYSSINS (FR)**
• **MORALES, Sophie**
**38760 VARCES (FR)**
• **PALACIOS LALOY, Augustin**
**38000 GRENOBLE (FR)**

(74) Mandataire: **Brevalex**
**Tour Trinity**
**1 B Place de la Défense**
**92400 Courbevoie (FR)**

(56) Documents cités:
**EP-A2- 2 998 758**

• SVENJA KNAPPE ET AL: "Microfabricated Optically-Pumped Magnetometers for Biomagnetic Applications", JOURNAL OF PHYSICS: CONFERENCE SERIES, INSTITUTE OF PHYSICS PUBLISHING, BRISTOL, GB, vol. 723, no. 1, 4 juillet 2016 (2016-07-04), page 12055, XP020304858, ISSN: 1742-6596, DOI: 10.1088/1742-6596/723/1/012055 [extrait le 2016-07-04]
• JIMENEZ-MARTINEZ R ET AL: "Sensitivity Comparison of Mx and Frequency-Modulated Bell-Bloom Cs Magnetometers in a Microfabricated Cell", IEEE TRANSACTIONS ON INSTRUMENTATION AND MEASUREMENT, IEEE SERVICE CENTER, PISCATAWAY, NJ, US, vol. 59, no. 2, 18 septembre 2009 (2009-09-18), pages 372-378, XP011295800, ISSN: 0018-9456
• SHUJI TAUE ET AL: "Magnetic Field Mapping and Biaxial Vector Operation for Biomagnetic Applications Using High-Sensitivity Optically Pumped Atomic Magnetometers", JAPANESE JOURNAL OF APPLIED PHYSICS, vol. 50, 28 octobre 2011 (2011-10-28), page 116604, XP055269130, JP ISSN: 0021-4922, DOI: 10.1143/JJAP.50.116604
• WYLLIE R ET AL: "Magnetocardiography with a modular spin-exchange relaxation free atomic magnetometer array", ARXIV.ORG, CORNELL UNIVERSITY LIBRARY, 201 OLIN LIBRARY CORNELL UNIVERSITY ITHACA, NY 14853, 23 juin 2011 (2011-06-23), XP080511081, DOI: 10.1088/0031-9155/57/9/2619

- ORANG ALEM ET AL: "Fetal magnetocardiography measurements with an array of microfabricated optically pumped magnetometers", PHYSICS IN MEDICINE AND BIOLOGY, INSTITUTE OF PHYSICS PUBLISHING, BRISTOL GB, vol. 60, no. 12, 4 juin 2015 (2015-06-04), pages 4797-4811, XP020286626, ISSN: 0031-9155, DOI: 10.1088/0031-9155/60/12/4797 [extrait le 2015-06-04]
- ANTHONY P. COLOMBO ET AL: "Four-channel optically pumped atomic magnetometer for magnetoencephalography", OPTICS EXPRESS, vol. 24, no. 14, 29 juin 2016 (2016-06-29), page 15403, XP055375418, DOI: 10.1364/OE.24.015403

## Description

## DOMAINE TECHNIQUE

Le domaine de l'invention est celui de l'imagerie des champs biomagnétiques, et concerne plus particulièrement les réseaux de magnétomètres vectoriels utilisés notamment en magnétocardiographie ou en magnétoencéphalographie.

## ÉTAT DE LA TECHNIQUE ANTÉRIEURE

Le principe de mesure des magnétomètres atomiques vectoriels est basé sur l'utilisation d'au moins un harmonique parmi plusieurs générés au moyen d'une source d'excitation. Ces magnétomètres emploient une cellule remplie d'un gaz d'atomes, une source laser qui émet un faisceau polarisé ainsi qu'un photo-détecteur apte à délivrer un signal de sortie représentatif du faisceau ayant traversé la cellule. Une bobine entoure la cellule, alimentée par un générateur de fréquence pour générer un champ magnétique d'excitation, sinusoïdal de fréquence $\dfrac{\omega}{2\pi}$, perpendiculaire à la direction de polarisation des photons issus du laser s'ils sont polarisés rectilignement et perpendiculaire au faisceau laser s'ils sont polarisés circulairement. La projection du champ magnétique sur la direction du champ d'excitation sinusoïdale est ainsi mesurée.

Le signal observée par le photo-détecteur contient des résonances impaires aux fréquences $\dfrac{(2q+1)\omega}{2\pi}$ (avec q un entier positif ou nul) qui sont proportionnelles au champ magnétique à mesurer. Ces résonances impaires, dont seule la première est en réalité utilisée, s'annulent pour un champ magnétique total nul. L'observation de la première résonance permet ainsi de mesurer un champ magnétique $B_0$ via l'asservissement d'un champ magnétique de compensation $B_C$ dont l'amplitude est ajustée afin que la somme $B_C + B_0$ soit maintenue à zéro en permanence. De cette manière, la connaissance du champ de compensation permet de connaître le champ magnétique ambiant $B_0$ puisque Bc = -$B_0$.

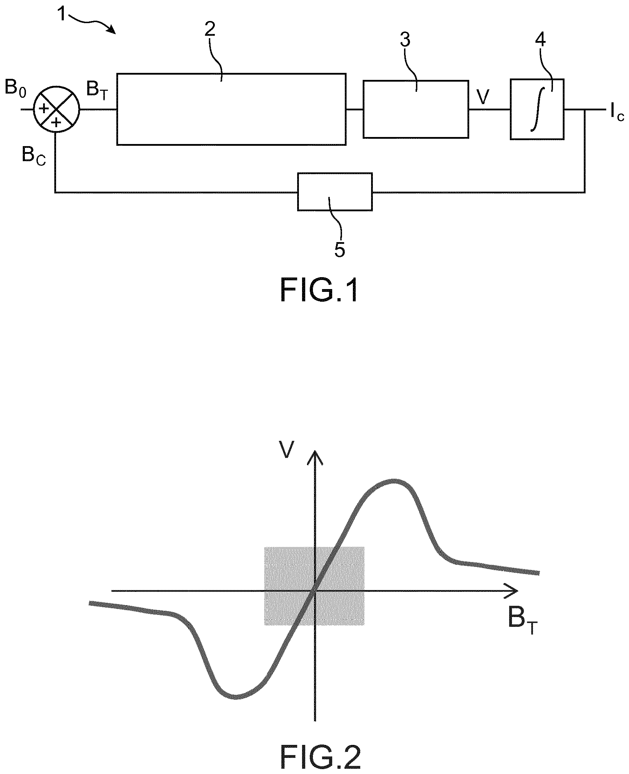

Cet asservissement en champ nul est représenté sur la figure 1. Le magnétomètre 1 comprend une source d'excitation 2 permettant la résonance, par exemple une bobine entourant la cellule et alimentée par un générateur de fréquence, et un photo-détecteur 3 permettant de mesurer l'amplitude d'un signal de sortie à un harmonique de la fréquence d'oscillation de la source d'excitation. Cette amplitude, et la valeur de courant $I_C$ calculée à partir de cette amplitude au moyen d'un intégrateur 4, s'annulent pour un champ magnétique total

$B_T$ nul. On applique pour ce faire le champ magnétique de compensation $B_C$ au moyen d'une bobine 5 alimentée par un courant $I_C$. La mesure du courant $I_C$ injecté dans la bobine 5 permet de connaître, via la fonction de transfert courant/champ magnétique de la bobine 5, la valeur du champ magnétique de compensation $B_C$ et donc celle du champ ambiant $B_0$.

On a représenté sur la figure 2 la courbe de résonance représentant l'amplitude V du signal mesuré par le photo-détecteur 3 en fonction du champ magnétique total $B_T$. Cette courbe présente une portion linéaire lorsque le champ magnétique total est faible et au voisinage de laquelle l'amplitude est directement proportionnelle au champ magnétique selon une pente de résonance. On comprend que l'asservissement en champ nul permet d'augmenter la dynamique de mesure en venant opérer le magnétomètre dans cette portion linéaire, y compris lorsque le champ magnétique à mesurer n'est pas suffisamment faible.

L'asservissement décrit en référence à la figure 1 est nécessaire pour chaque axe de mesure des magnétomètres. Il faut ainsi trois asservissements de ce type, afin de mesurer les trois composantes du champ ambiant $B_0$. Or la superposition au niveau d'un seul magnétomètre de plusieurs champs magnétiques d'excitation à des fréquences différentes pour couvrir les différents axes du magnétomètre dégrade la pente de résonance. Et dans le cadre d'un réseau de magnétomètres, les amplitudes et directions des champs d'excitation générés par un magnétomètre vont également modifier celles de leurs proches voisins. Ces modifications doivent être prises en compte pour générer des champs magnétiques d'excitation ayant les bonnes amplitudes et directions pour chaque magnétomètre.

Par ailleurs, toujours dans le cadre d'un réseau de magnétomètres, le champ magnétique de compensation $B_C$ généré par les bobines d'un magnétomètre est également vu par les autres magnétomètres du réseau, les plus proches en particulier. Il vient perturber les mesures effectuées par les autres magnétomètres du réseau et peut également conduire à des instabilités des magnétomètres.

Ainsi, la mise en réseau de magnétomètres vient impacter les champs magnétiques d'excitation ainsi que la fonction de transfert des magnétomètres asservis.

Le document Svenja Knappe et al., « Microfabricated Optically-Pumped Magnetometers for Biomagnétic Applications », Journal of Physics : Conférence Séries, Institute of Physics Publishing, Bristol, GB, vol.723, n°1, 4/07/2016, page 12055, propose un réseau de magnétomètres asservis en champ nul au moyen de champs de compensation, ce qui entraîne des problèmes de diaphonie (cross-talk).

## EXPOSÉ DE L'INVENTION

L'invention a pour objectif de quantifier cet impact lors d'une phase de calibration d'un réseau de magnétomètres vectoriels à pompage optique. Elle vise ainsi à proposer une solution pour estimer les couplages entre les magnétomètres du réseau. La connaissance de ces couplages permettrait alors, lors d'une phase de mesure, de corriger l'amplitude et la direction des champs magnétiques d'excitation des résonances paramétriques, et donc d'améliorer la précision des magnétomètres. Cette connaissance permettrait également de compenser numériquement les biais induits par les champs magnétiques de compensation des magnétomètres employés en mode asservi.

Afin de déterminer ces couplages qui vont permettre de limiter la dégradation de la précision des magnétomètres liée à leur utilisation en réseau, l'invention propose un procédé selon la revendication 1.

Certains aspects préférés mais non limitatifs de ce procédé sont définis dans les revendications dépendantes 2-7.

L'invention concerne également un appareil tel que défini par la revendication 8.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels ;

- la figure 1, déjà décrite ci-dessus, illustre le principe de l'asservissement en champ magnétique nul mis en oeuvre en phase de mesure ;
- la figure 2, déjà décrite ci-dessus, illustre la portion linéaire de la courbe de résonance observable en présence d'un champ magnétique faible ;
- la figure 3 est un schéma illustrant différentes étapes d'un procédé de calibration conforme à l'invention.

## EXPOSÉ DÉTAILLÉ DE MODES DE RÉALISATION PARTICULIERS

L'invention porte sur un appareil de mesure de champ magnétique, notamment un appareil doté de N (entier naturel au moins égal à deux) magnétomètres vectoriels à pompage optique agencés en réseau et trouvant en particulier application dans le domaine médical pour l'imagerie des champs biomagnétiques, par exemple en magnétoencéphalographie ou en magnétocardiographie. Dans ces applications, les spécifications de précision sur la mesure magnétique faite par chaque magnétomètre du réseau, liées au besoin de localisation des signaux magnétiques qu'il mesure, peuvent être de quelques millimètres.

L'invention porte plus particulièrement sur un appareil configuré pour permettre la mise en oeuvre du procédé de calibration des magnétomètres décrit ci-après. Ce procédé permet d'estimer l'impact de la mise en réseau des magnétomètres, en venant mesurer la perturbation qu'un champ généré par l'un des magnétomètres vient introduire à la mesure réalisée par un autre magnétomètre.

Le réseau de magnétomètres vectoriels à pompage optique est typiquement porté par une structure, par exemple conformable, destinée à être portée par un utilisateur. En magnétoencéphalographie, la structure prend la forme d'un casque à même d'être installé sur le crâne de l'utilisateur.

Du fait de la présence du réseau et en utilisation usuelle de celui-ci, le champ magnétique mesuré au niveau d'un magnétomètre intègre des contributions de l'ensemble des autres magnétomètres. Ainsi, le champ magnétique $B_{Gi}$ généré par un magnétomètre d'indice i (en réalité par une bobine d'un magnétomètre) induit un champ $B_{Mj}$ au niveau d'un magnétomètre d'indice j (en réalité sur un axe de mesure d'un magnétomètre) selon

$$C_{ij} = \frac{B_{Mj}}{B_{Gi}}$$

un coefficient de couplage.

On cherche à déterminer, lors d'une phase de calibration préalable à une utilisation usuelle du réseau de magnétomètres, la matrice de couplage $\overline{\overline{C_{ij}}}$ constitué des différents coefficients de couplage. Cette matrice est de taille 3N*3N, où N correspond au nombre de magnétomètres dans le réseau et le chiffre 3 illustre les trois axes des magnétomètres. On a ainsi

$$B_{Mj} = \sum_i C_{ij}.B_{Gi}$$

, avec les indices i et j variant de 1 i à 3N, chaque composante d'un champ généré par un magnétomètre étant vue sur chacun des axes de mesure des magnétomètres (on a ainsi trois mesures $B_{Mj}$ intégrant chacune la contribution de chacun des trois champs $B_{Gi}$).

Lors d'une phase de mesure ultérieure à cette phase de calibration, on pourra, en ayant recours à une inversion de la matrice de couplage, remonter pour chaque magnétomètre au champ magnétique réel, tel qu'il serait mesuré en l'absence du réseau.

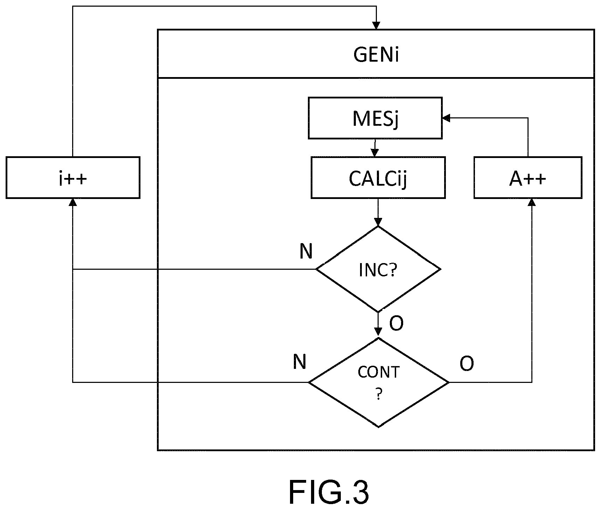

Les différentes étapes de cette phase de calibration, ou phase d'estimation du couplage entre magnétomètres du réseau, sont décrites par la suite en référence à la figure 3.

Dans cette phase de calibration, les magnétomètres sont de préférence opérés en boucle ouverte, i.e. sans l'avertissement en champ nul décrit précédemment qui correspond à une opération en boucle fermée. En boucle ouverte, il n'y a pas de champ de compensation et les magnétomètres mesurent le champ magnétique ambiant $B_0$ directement via la mesure de l'amplitude V de la résonance et grâce à la connaissance de la pente de la portion linéaire de la courbe de résonance. Ainsi, l'amplitude du champ mesurée doit être suffisamment faible pour que la résonance s'opère dans sa portion linéaire, soit en pratique $\pm 36$ nT pour de l'hélium 4, muni d'un temps de relaxation de 1 ms et d'un rapport gyromagnétique de $2\pi$ x 28.10$^{-9}$ rad.s$^{-1}$.T$^{-1}$. Bien entendu, les magnétomètres peuvent supporter des champs plus grands que 36 nT, mais la mesure ne doit pas être faite dans ces conditions, sauf à prévoir un champ de compensation constant pour se ramener dans la portion linéaire de la résonance comme cela est décrit dans la demande de brevet EP 2 998 758 A2.

Dans la phase de calibration, les magnétomètres peuvent alternativement être opérés en boucle fermée, mais il est alors nécessaire pour éviter les interférences de les utiliser l'un après l'autre en phase de mesure d'un champ de référence, ce qui s'avère N fois plus long à réaliser.

On a vu précédemment que chaque magnétomètre du réseau comprend au moins une bobine, trois typiquement, qui permet de générer un champ magnétique d'amplitude et de direction connues. Dans la phase de calibration, chaque bobine de chaque magnétomètre génère tour à tour un champ magnétique d'amplitude connue, pendant que tous les magnétomètres (y compris celui qui dont la bobine génère le champ magnétique) mesurent le champ magnétique résultant, afin d'établir la matrice de couplage et ses 3N x 3N coefficients.

Le procédé de calibration du réseau de N magnétomètres vectoriels à pompage optique comprend ainsi une étape de détermination d'une matrice de coefficients de couplage entre magnétomètres du réseau, cette étape comportant les opérations suivantes, mises en oeuvre pour l'un des magnétomètres du réseau, dit magnétomètre de référence, d'indice i.

Le magnétomètre de référence est opéré pour réaliser la génération séquentielle GENi de m champs magnétiques de référence d'amplitudes connues et de directions distinctes, m étant un entier au moins égal à un, typiquement égal à trois. Ainsi les bobines du magnétomètre de référence sont utilisées à tour de rôle pour générer un champ $B_{Gi}$.

L'ensemble des N magnétomètres du réseau, et donc y compris le magnétomètre de référence, vient procéder à la mesure séquentielle MESj des m champs de référence suivant n axes, n étant un entier au moins égal à un, typiquement égal à trois.

A titre d'exemple, les magnétomètres mesurent simultanément le champ issu de la sinusoïde d'amplitude $B_{Gi}$, par exemple à 10 Hz à l'aide d'une détection synchrone à 10 Hz, pour obtenir précisément $B_{Mj}$. Le bruit des magnétomètres est typiquement de l'ordre 100 fT/VHz entre 0.1 et 300 Hz. Un filtre passe-bas d'ordre 4 à 1 Hz peut être utilisé en sortie de détection synchrone pour obtenir un bruit efficace voisin de 100 fT.

Puis, à partir des mesures réalisées simultanément par tous les axes de tous les magnétomètres du réseau lors du créneau temporel dédié à la génération d'un des m champs de référence par le magnétomètre de référence, on vient procéder à la détermination CALCij de coefficients de couplage entre le magnétomètre de référence et chacun des N magnétomètres du réseau. Cette détermination comprend le calcul de coefficients

$$C_{ij} = \frac{B_{Mj}}{B_{Gi}}$$

de couplage en effectuant les N ratios entre les N mesures $B_{Mj}$ dudit un des m champs de référence suivant l'un des n axes et l'amplitude $B_{Gi}$ dudit un des m champs de référence. Ce calcul est bien entendu effectué pour les mesures dudit un des m champs de référence suivant chacun des n axes.

Une fois ces coefficients calculés, on peut venir réitérer les opérations de génération séquentielle GENi, de mesure MESj et de détermination CALCij en adoptant à chaque itération un nouveau magnétomètre du réseau en tant que magnétomètre de référence, comme cela est illustré par le bloc incrémental « i++ » sur la figure 3. Le procédé est arrêté lorsque tous les coefficients de couplage ont été calculés, i.e. après que chaque magnétomètre du réseau ait été utilisé en tant que magnétomètre de référence.

Dans un mode de réalisation possible de l'invention, lors de l'opération de détermination CALCij des coefficients de couplage, si l'amplitude du champ mesuré $B_{Mj}$ est assez grande pour que l'incertitude sur l'estimation d'un coefficient de couplage $C_{ij}$ soit faible, alors la valeur de ce coefficient est validée. Sinon, ce coefficient $C_{ij}$ est calculé après avoir augmenté l'amplitude du champ de référence $B_{Gi}$ pour permettre de réduire l'incertitude de mesure sur $B_{Mj}$ et donc l'incertitude sur $C_{ij}$.

Ainsi, pour des raisons de précision de mesure des coefficients de couplage et de dynamique de mesure des capteurs en boucle ouverte, l'amplitude des champs magnétiques à générer $B_{Gi}$ peut être augmentée à mesure que les coefficients de couplage concernent des magnétomètres de plus en plus éloignés. En effet, l'amplitude de $B_{Gi}$ doit être faible vis-à-vis de la dynamique de mesure des magnétomètres opérés en boucle ouverte, mais doit être par ailleurs suffisamment grande pour que l'incertitude sur les champs magnétiques mesurés $B_{Mj}$ soit compatible avec l'objectif de précision sur le calcul des $C_{ij}$. Ces deux contraintes sont parfois antinomiques, et l'invention propose de faire varier l'amplitude de l'amplitude de $B_{Gi}$, en adoptant une valeur initiale faible, par exemple de 10 nT, et en venant l'augmenter pour permettre le calcul de coefficients de couplage suffisamment certains pour des magnétomètres lointains.

Ainsi, dans ce mode de réalisation, la détermination des coefficients de couplage comprend en outre la mesure d'une incertitude INC ? portant sur chaque coefficient de couplage calculé pour ledit un des m champs de référence et une validation d'un coefficient de couplage calculé lorsque la mesure de l'incertitude portant sur le coefficient de couplage calculé est inférieure à un seuil. Lorsque tous les coefficients de couplage sont validés, pour chacun des m champs de référence, (« N » en sortie du bloc « INC ? » sur la figure 3) on procède au choix d'un nouveau magnétomètre de référence (bloc incrémental « i++ ») et à la réitération des différentes opérations décrites ci-dessus.

En revanche, lorsque la mesure de l'incertitude portant sur un coefficient de couplage calculé est supérieure audit seuil (« O » en sortie du bloc « INC ? » sur la figure 3), on procède à l'augmentation « A++ » de l'amplitude dudit un des m champs de référence, par exemple d'un facteur 10, et à la réitération du calcul du coefficient de couplage en effectuant le ratio entre une nouvelle mesure dudit un des m champs de référence suivant l'un des n axes et l'amplitude augmentée dudit un des m champs de référence.

La mesure de l'incertitude portant sur un coefficient de couplage calculé comprend le calcul d'une incertitude absolue $\Delta C_{ij}$ et/ou d'une incertitude relative

$$\frac{\Delta C_{ij}}{\left|C_{ij}\right|}$$

. Si l'une et/ou l'autre de ces incertitudes est supérieur à un seuil (seuil absolu $\Delta C_{ij\,max}$ pour l'incertitude absolue ; seuil relatif $\Delta_R C_{ij}$ pour l'incertitude relative), on procède à l'augmentation A++ de l'amplitude du champ de référence.

L'incertitude absolue $\Delta C_{ij}$ est par exemple calculée selon

$$\Delta C_{ij} = \frac{\Delta B_{Mj}}{B_{Gi}} + \Delta_R B_G \cdot \left|C_{ij}\right|$$

, avec $\Delta B_{Mj}$ =$bB_M + \Delta_R B_M \cdot |B_{Mj}|$, où $B_{Gi}$ correspond à l'amplitude du champ de référence, $B_{Mj}$ correspond à l'amplitude du champ mesuré, $\Delta_R B_G$ correspond à l'incertitude relative sur l'amplitude du champ de référence (par exemple égale à 10⁻³), $\Delta_R B_M$ correspond à l'incertitude relative sur l'amplitude du champ mesuré (par exemple égale à 10⁻³) et $bB_M$ correspond au bruit efficace affectant les magnétomètres pendant la durée de mesure choisie ($bB_M$ est par exemple de 100 fT). Le seuil absolu $\Delta C_{ij\,max}$ pour l'incertitude absolue est par exemple de 10⁻⁴, et le seuil relatif $\Delta_R C_{ij}$ pour l'incertitude relative est par exemple de 5.10⁻³.

Dans une variante de réalisation possible, l'amplitude du champ de référence n'est pas augmentée si les coefficients de couplage qui n'ont pas pu être calculés avec suffisamment de précision présentent une contribution négligeable, i.e. ils sont si faibles qu'ils illustrent une contribution négligeable du champ généré au niveau du champ mesuré, typiquement parce que les magnétomètres sont distants et donc de faible couplage.

Dans cette variante, qui est représentée sur la figure 3, le procédé comprend l'estimation d'une contribution au couplage CONT ? portant sur les coefficients de couplage calculés dont la mesure d'incertitude est supérieure audit seuil. L'amplitude dudit un des m champs de référence n'est alors augmentée « A++ » que si ladite estimation de la contribution au couplage est supérieure à un seuil (sortie « O » du bloc « CONT ? »). Dans le cas contraire (sortie « N » du bloc « CONT ? »), on n'augmente pas l'amplitude du champ de référence, on affecte une valeur prédéterminée (par exemple zéro) aux coefficients de couplage incertains, on procède au choix d'un nouveau magnétomètre de référence (bloc incrémental « i++ ») et à la réitération des différentes opérations décrites ci-dessus.

Afin de fixer des ordres de grandeurs, on peut relever que le champ magnétique décroit avec le cube de la distance, si bien que seuls les couplages avec les premiers voisins contribuent réellement. La Demanderesse a pu calculer, pour un réseau 2D de magnétomètres agencés selon une matrice de 10*10 magnétomètres dont le pas est de 3 cm, que les 8 premiers voisins (cardinaux et diagonaux) d'un magnétomètre central fournissent 91% de l'information (poids cumulé des $C_{ij}$ des 8 premiers voisins) qui permet de calculer le champ magnétique vu au niveau du magnétomètre central. En incluant la deuxième couronne et ses 16 magnétomètres supplémentaires, on atteint 95 %.

Dans cette variante, on vient par exemple estimer la contribution possible des coefficients de couplage incertains, et la comparer à un seuil. Cette estimation est par exemple réalisée en comptant le nombre Ncci de coefficients de couplage incertains et en leur affectant la plus faible valeur des coefficients de couplage certains et validés Cimin (les coefficients de couplage incertains sont nécessairement plus petits que cette valeur). La contribution possible des coefficients de couplage incertains peut alors s'exprimer comme Ncci*Cimin. Le seuil peut correspondre à l'incertitude sur le coefficient de couplage le plus important $C_{ijmax}$ dans la matrice de couplage, soit $\Delta_R C_{ij} * C_{ij\,max}$. La valeur de ce coefficient de couplage le plus important $C_{ijmax}$ peut être prédéterminée : elle est par exemple égale à 1, ce qui correspond à la diagonale de la matrice de couplage (c'est-à-dire un auto-couplage).

L'étape de détermination de la matrice de coefficients de couplage, dont on a décrit ci-dessus les différentes opérations, peut être réitérée après modification des amplitudes et directions des m champs magnétiques de référence générés par chacun des magnétomètres du réseau lorsqu'il est opéré comme magnétomètre du réseau. En effet, au niveau de chaque magnétomètre, la direction et l'amplitude des champs d'excitation sont modifiées par la présence des magnétomètres voisins. L'impact sur la mesure est du deuxième ordre. Pour être sûr que cet impact soit négligeable, on vient donc actualiser l'amplitude et la direction des champs de référence des magnétomètres en fonction des coefficients de couplage déterminés au cours d'une itération de l'étape de détermination de la matrice de coefficients de couplage et les utiliser au cours d'une itération suivante de cette étape.

Dans un mode de réalisation possible, si l'écart entre les deux itérations conduit à une évolution de la correction apportée aux champs de référence négligeable au regard de la précision visée, on considère que les coefficients de couplage calculés sont connus avec suffisamment de précision et qu'il n'est pas nécessaire de les mesurer de nouveau en actualisant une nouvelle fois les valeurs des champs de référence. Dans ce mode de réalisation, le procédé peut comprendre une mesure d'écart entre les coefficients de couplage calculés entre deux itérations successives de l'étape de détermination de la matrice de coefficients de couplage, et un arrêt de la réitération de cette étape lorsque la mesure d'écart est inférieure à un seuil.

Cette mesure d'écart peut être, pour chaque coefficient de couplage calculé, une mesure absolue et/ou une mesure relative. La mesure absolue s'exprime par exemple selon $\left| \dfrac{C_{ij} - C_{ijref}}{C_{ij}} \right|$ et la mesure relative s'exprime par exemple selon $|C_{ij} - C_{ijref}|$, où $C_{ij}$ et $C_{ijref}$ correspondent aux valeurs d'un coefficient de couplage déterminée au cours de deux itérations successives de l'étape de détermination de la matrice de couplage. S'il existe un couple i, j pour lequel l'une et/ou l'autre de ces mesures est supérieur à un seuil (seuil absolu $\Delta C_{ij\,max}$ pour la mesure absolue ; seuil relatif $\Delta_R C_{ij}$ pour l'incertitude relative), on réitère l'étape de détermination de la matrice de couplage après actualisation des valeurs des champs de référence.

On notera que pour les premières valeurs de $C_{ijref}$ et l'initialisation de la matrice de couplage, on peut choisir une matrice de zéro ou une matrice construite grâce à une connaissance a priori de la localisation relative des magnétomètres.

L'invention s'étend également à un appareil de mesure de champ magnétique apte à mettre en oeuvre le procédé précédemment décrit, et notamment à un appareil comprenant un réseau de N magnétomètres vectoriels à pompage optique et comportant n axes de mesures, et un calculateur, les magnétomètres du réseau étant apte à mettre en oeuvre les opérations de génération séquentielle GENi, par l'un des magnétomètres du réseau dit magnétomètre de référence, de m champs magnétiques de référence d'amplitudes connues et de directions distinctes, et, lors d'un créneau temporel dédié à la génération de chacun des m champs magnétiques de référence par le magnétomètre de référence de l'opération de génération séquentielle, de mesure MESj, par chacun des N magnétomètres du réseau, des m champs magnétiques de référence suivant les n axes de mesure, et le calculateur étant configuré pour calculer CALCij des coefficients de couplage entre le magnétomètre de référence et chacun des N magnétomètres du réseau en effectuant les ratio entre les N mesures d'un des m champs magnétiques de référence suivant l'un des n axes de mesure et l'amplitude connue dudit un des m champs magnétiques de référence, m et n étant des entiers au moins égaux à 1.

## Revendications

1. Procédé de détermination d'un couplage entre magnétomètres d'un réseau de N magnétomètres vectoriels à pompage optique et comportant n axes de mesure, **caractérisé en ce qu'**il comporte les opérations suivantes :

   - génération séquentielle (GENi), par l'un des magnétomètres du réseau dit magnétomètre de référence, de m champs magnétiques de référence d'amplitudes connues et de directions distinctes ;
   - lors d'un créneau temporel dédié à la génération de chacun des m champs magnétiques de référence par le magnétomètre de référence de l'opération de génération séquentielle, mesure (MESj), par chacun des N magnétomètres du réseau, des m champs magnétiques de référence suivant les n axes de mesure ;
   - détermination (CALCij) de coefficients de couplage entre le magnétomètre de référence et chacun des N magnétomètres du réseau, ladite détermination comprenant le calcul de coefficients de couplage en effectuant les ratios entre les N mesures d'un des m champs magnétiques de référence suivant l'un des n axes de mesure et l'amplitude connue dudit un des m champs magnétiques de référence ;
   - m et n étant des entiers au moins égaux à 1.

2. Procédé selon la revendication 1, dans lequel la détermination des coefficients de couplage comprend en outre la mesure d'une incertitude (INC?) portant sur chaque coefficient de couplage calculé et une validation d'un coefficient de couplage calculé lorsque la mesure de l'incertitude portant sur le coefficient de couplage calculé est inférieure à un seuil.

3. Procédé selon la revendication 2, comprenant, lorsque la mesure de l'incertitude portant sur un coefficient de couplage calculé est supérieure audit seuil, l'augmentation (A++) de l'amplitude connue dudit un des m champs magnétiques de référence et la réitération du calcul du coefficient de couplage en générant ledit un des m champs magnétiques de référence d'amplitude connue augmentée et en effectuant le ratio entre la mesure dudit un des m champs magnétiques de référence suivant l'un des n axes de mesure et l'amplitude connue augmentée dudit un des m champs magnétiques de référence.

4. Procédé selon la revendication 3, comprenant l'estimation d'une contribution au couplage (CONT ?) des coefficients de couplage calculés dont la mesure d'incertitude est supérieure audit seuil, et dans lequel l'amplitude connue dudit un des m champs magnétiques de référence n'est augmentée (A++) que si ladite estimation de la contribution au couplage est supérieure à un seuil.

**5.** Procédé selon l'une des revendications 1 à 4, dans lequel les opérations de génération séquentielle, de mesure et de détermination sont réitérées en adoptant à chaque itération (i++) un nouveau magnétomètre du réseau en tant que magnétomètre de référence.

**6.** Procédé selon la revendication 5, comprenant en outre la réitération de l'étape de détermination de la matrice de coefficients de couplage, après modification des amplitudes et directions des m champs magnétiques de référence générés par chacun des magnétomètres du réseau lorsqu'il est opéré comme magnétomètre de référence.

**7.** Procédé selon la revendication 6, comprenant en outre une mesure d'écart entre les coefficients de couplage calculés lors de deux itérations successives de l'étape de détermination de la matrice de coefficients de couplage, et un arrêt de la réitération de l'étape de détermination de la matrice de coefficients de couplage lorsque la mesure d'écart est inférieure à un seuil.

**8.** Appareil de mesure de champ magnétique, comprenant un réseau de N magnétomètres vectoriels à pompage optique et comportant n axes de mesure, et un calculateur, **caractérisé en ce que** les magnétomètres du réseau sont configurés pour mettre en oeuvre les opérations de génération séquentielle (GENi), par l'un des magnétomètres du réseau dit magnétomètre de référence, de m champs magnétiques de référence d'amplitudes connues et de directions distinctes, et, lors d'un créneau temporel dédié à la génération de chacun des m champs magnétiques de référence par le magnétomètre de référence de l'opération de génération séquentielle, de mesure (MESj), par chacun des N magnétomètres du réseau, des m champs magnétiques de référence suivant les n axes de mesure, et **en ce que** le calculateur est configuré pour calculer (CALCij) des coefficients de couplage entre le magnétomètre de référence et chacun des N magnétomètres du réseau en effectuant les ratio entre les N mesures d'un des m champs magnétiques de référence suivant l'un des n axes de mesure et l'amplitude connue dudit un des m champs magnétiques de référence, m et n étant des entiers au moins égaux à 1.

**Patentansprüche**

**1.** Verfahren zur Bestimmung einer Kopplung zwischen Magnetometern eines Netzes von N optisch gepumpten Vektormagnetometern, n Messachsen beinhaltend, **dadurch gekennzeichnet, dass** es folgende Vorgänge beinhaltet:

- sequenzielle Erzeugung (GENi), durch ein Magnetometer des Netzes, Referenzmagnetometer genannt, von m Referenzmagnetfeldern bekannter Amplituden und unterschiedlicher Richtungen;
- während eines Zeitfensters, das der Erzeugung jedes der m Referenzmagnetfelder durch das Referenzmagnetometer des Vorgangs der sequenziellen Erzeugung gewidmet ist, Messung (MESj), durch jedes der N Magnetometer des Netzes, der m Referenzmagnetfelder entlang den n Messachsen;
- Bestimmung (CALCij) von Koeffizienten der Kopplung zwischen dem Referenzmagnetometer und jedem der N Magnetometer des Netzes, wobei die Bestimmung die Berechnung von Kopplungskoeffizienten durch Vornehmen der Verhältnisse zwischen den N Messungen eines der m Referenzmagnetfelder entlang einer der n Messachsen und der bekannten Amplitude des einen der m Referenzmagnetfelder umfasst;
- wobei m und n ganze Zahlen sind, die mindestens gleich 1 sind.

**2.** Verfahren nach Anspruch 1, wobei die Bestimmung der Kopplungskoeffizienten ferner die Messung einer tragenden Unsicherheit (INC?) für jeden berechneten Kopplungskoeffizienten umfasst und eine Validierung eines berechneten Kopplungskoeffizienten, wenn die Messung der tragenden Unsicherheit für den berechneten Kopplungskoeffizienten unter einem Schwellenwert liegt.

**3.** Verfahren nach Anspruch 2, umfassend, wenn die Messung der tragenden Unsicherheit für einen berechneten Kopplungskoeffizienten größer als der Schwellenwert ist, das Erhöhen (A++) der bekannten Amplitude des einen der m Referenzmagnetfelder und die Re-Iteration der Berechnung des Kopplungskoeffizienten durch Erzeugen des einen der m Referenzmagnetfelder mit erhöhter bekannter Amplitude und durch Vornehmen des Verhältnisses zwischen der Messung des einen der m Referenzmagnetfelder entlang einer der n Messachsen und der bekannten Amplitude des einen der m Referenzmagnetfelder.

**4.** Verfahren nach Anspruch 3, die Schätzung eines Beitrags zur Kopplung (CONT?) des berechneten Kopplungskoeffizienten umfassend, deren Messung der Unsicherheit größer als der Schwellenwert ist, und bei denen die bekannte Amplitude des einen der m Referenzmagnetfelder nur erhöht wird (A++), wenn die Schätzung des Beitrags zur Kopplung größer als ein Schwellenwert ist.

5. Verfahren nach einem der Ansprüche 1 bis 4, wobei die Vorgänge der sequenziellen Erzeugung, der Messung und der Bestimmung re-iteriert werden, indem bei jeder Iteration (i++) ein neues Magnetometer des Netzes als Referenzmagnetometer verwendet wird.

6. Verfahren nach Anspruch 5, ferner die Re-Iteration des Schrittes zur Bestimmung der Matrix der Kopplungskoeffizienten umfassend nach Änderung der Amplituden und Richtungen der m Referenzmagnetfelder, die von jedem der Magnetometer des Netzes erzeugt wurden, wenn es als Referenzmagnetometer betrieben wird.

7. Verfahren nach Anspruch 6, ferner eine Messung des Abstands zwischen den berechneten Kopplungskoeffizienten umfassend bei zwei aufeinanderfolgenden Iterationen des Bestimmungsschritts der Matrix des Kopplungskoeffizienten, und einen Stopp die Re-Iteration des Bestimmungsschritts der Matrix des Kopplungskoeffizienten, wenn die Messung des Abstands kleiner als ein Schwellenwert ist.

8. Magnetfeldmessgerät, ein Netz von N optisch gepumpten Vektormagnetometern umfassend, und n Messachsen beinhaltend, und einen Rechner, **dadurch gekennzeichnet, dass** die Magnetometer des Netzes konfiguriert sind, um die Vorgänge der sequenziellen Erzeugung (GENi), durch eines der Magnetometer des Netzes, Referenzmagnetometer genannt, von m Referenzmagnetfeldern bekannter Amplituden und unterschiedlicher Richtungen durchzuführen, und während eines Zeitfensters, das der Erzeugung jedes der m Referenzmagnetfelder durch das Referenzmagnetometer des Vorgangs der sequenziellen Erzeugung gewidmet ist, der Messung (MESj), durch jedes der N Magnetometer des Netzes der m Referenzmagnetfelder entlang den n Messachsen, und dass der Rechner konfiguriert ist, um Kopplungskoeffizienten zwischen dem Referenzmagnetometer und jedem der N Magnetometern des Netzes zu berechnen (CALCij), indem er das Verhältnis zwischen den N Messungen eines der m Referenzmagnetfelder entlang einer der n Messachsen und der bekannten Amplitude des einen der m Referenzmagnetfelder vornimmt, wobei m und n ganze Zahlen sind, die mindestens gleich 1 sind.

**Claims**

1. A method for determining a coupling between magnetometers of an array of N vector magnetometers with optical pumping and including n measurement axes, **characterised in that** it includes the following operations:

   - sequential generation (GENi), by one of the magnetometers of the array called the reference magnetometer, of m reference magnetic fields of known amplitudes and distinct directions;
   - during a time slot dedicated to the generation of each of the m reference magnetic fields by the reference magnetometer of the sequential generation operation, measurement (MESj), by each of the N magnetometers of the array, of the m reference magnetic fields along the n measurement axes;
   - determination (CALCij) of coupling coefficients between the reference magnetometer and each of the N magnetometers of the array, said determination comprising the calculation of coupling coefficients by performing the ratios between the N measurements of one of the m reference magnetic fields according to one of the n measurement axes and the known amplitude of said one of the m reference magnetic fields;
   - m and n being integers at least equal to 1.

2. The method according to claim 1, wherein the determination of the coupling coefficients further comprises the measurement of an uncertainty (INC?) relating to each calculated coupling coefficient and a validation of a calculated coupling coefficient when the measurement of the uncertainty relating to the calculated coupling coefficient is less than a threshold.

3. The method according to claim 2, comprising, when the measurement of the uncertainty relating to a calculated coupling coefficient is greater than said threshold, the increase (A++) of the known amplitude of said one of the m reference magnetic fields and the reiteration of the calculation of the coupling coefficient by generating said one of the m reference magnetic fields of increased known amplitude and by carrying out the ratio between the measurement of said one of the m reference magnetic fields along one of the n measurement axes and the increased known amplitude of said one of the m reference magnetic fields.

4. The method according to claim 3, comprising the estimation of a contribution to the coupling (CONT?) of the calculated coupling coefficients whose measurement of uncertainty is greater than said threshold, and wherein the known amplitude of said one of the m reference magnetic fields is increased (A++) only if said estimation of the contribution to the coupling is greater than a threshold.

5. The method according to one of claims 1 to 4, wherein the operations of sequential generation, measurement and determination are reiterated by adopting at each iteration (i++) a new magnetometer of the array as reference magnetometer.

6. The method according to claim 5, further comprising repeating the step of determining the matrix of coupling coefficients, after modifying the amplitudes and directions of the m reference magnetic fields generated by each of the magnetometers of the array when it is operated as a reference magnetometer.

7. The method according to claim 6, further comprising measuring the difference between the coupling coefficients calculated during two successive iterations of the step of determining the matrix of coupling coefficients, and stopping the reiteration of the step of determining the matrix of coupling coefficients when the difference measurement is less than a threshold.

8. A magnetic field measurement device, comprising an array of N vector magnetometers with optical pumping and including n measurement axes, and a calculator, **characterised in that** the magnetometers of the array are configured to implement the operations of sequential generation (GENi), by one of the magnetometers of the array called reference magnetometer, of m reference magnetic fields of known amplitudes and distinct directions, and, during a time slot dedicated to the generation of each of the m reference magnetic fields by the reference magnetometer of the operation of sequential generation, of measurement (MESj), by each of the N magnetometers of the array, of the m reference magnetic fields along the n measurement axes, and **in that** the calculator is configured to calculate (CALCij) coupling coefficients between the reference magnetometer and each of the N magnetometers of the array by performing the ratios between the N measurements of one of the m reference magnetic fields along one of the n measurement axes and the known amplitude of said one of the m reference magnetic fields, m and n being integers at least equal to 1.

FIG.1

FIG.2

FIG.3

## RÉFÉRENCES CITÉES DANS LA DESCRIPTION

**Documents brevets cités dans la description**

- EP 2998758 A2

**Littérature non-brevet citée dans la description**

- Microfabricated Optically-Pumped Magnetometers for Biomagnétic Applications. **SVENJA KNAPPE et al.** Journal of Physics : Conférence Séries. Institute of Physics Publishing, 04 Juillet 2017, vol. 723, 12055